# EUROPEAN PATENT SPECIFICATION

(11) **EP 1 594 800 B1**
(45) Date of publication and mention of the grant of the patent: **24.01.2007**
(21) Application number: 04709673.0
(22) Date of filing: 10.02.2004
(51) Int. Cl.: B81C 1/00, G01P 15/08

(54) **METHOD OF MANUFACTURING AN ELECTRONIC DEVICE AND ELECTRONIC DEVICE**
VERFAHREN ZUR HERSTELLUNG EINER ELEKTRONISCHEN VORRICHTUNG UND ELEKTRONISCHE VORRICHTUNG
PROCEDE DE FABRICATION D'UN DISPOSITIF ELECTRONIQUE ET DISPOSITIF ELECTRONIQUE

(30) Priority: 11.02.2003 EP 03075398; 11.11.2003 EP 03104154
(43) Date of publication of application: 16.11.2005
(73) Proprietor: Koninklijke Philips Electronics N.V., 5621 BA Eindhoven (NL)
(72) Inventor: BOEZEN, Hendrik, NL-5656 AA Eindhoven (NL); DEN HARTOG, Sander, G., NL-5656 AA Eindhoven (NL); FRENCH, Patrick, J., NL-5656 AA Eindhoven (NL); MAKINWA, Kofi, A., A., NL-5656 AA Eindhoven (NL)
(74) Representative: Pennings, Johannes
(86) International application number: PCT/IB2004/050094
(87) International publication number: WO 2004/071943

(56) References cited:
- US-A- 5 408 112
- US-A- 6 104 073

## Description

This invention relates to a method of manufacturing an electronic device, comprising the steps of:
- providing a wafer with a first and an opposed second side, having first and second semiconductor layers with at least a layer of insulating material therebetween, at which first side a semiconductor circuit is provided comprising semiconductor elements that are defined in the first semiconductor layer, and
- forming a micro-electromechanical systems (MEMS) device comprising a movable electrode and a reference electrode in said wafer by etching trenches according to a desired pattern extending substantially perpendicularly to a plane in the wafer, and by releasing the movable electrode in that the trenches extend to the layer of insulating material that is selectively removed.

The invention also relates to an electronic device, comprising a substrate with a first and an opposed second side, having first and second semiconductor layers with at least a layer of insulating material therebetween, at which first side a semiconductor circuit is present comprising semiconductor elements that are defined in the first semiconductor layer, and further comprising a micro-electromechanical systems (MEMS) device, said MEMS device having a reference electrode and a movable electrode, said MEMS device being electrically coupled to said semiconductor circuit, said insulating layer being removed locally so as to allow the movable electrode to be movable.

Such a method and such a device are for instance known from US Patent No. 6,232,140. This patent discloses an integrated capacitive acceleration sensor including a semiconductor body defining a movable electrode facing at least one reference electrode. The reference electrode is usually mechanically fixed. The semiconductor device is defmed in the first semiconductor layer of monocrystalline silicon. The MEMS device is also formed in this first semiconductor layer. By etching trenches in this layer, the electrodes are defined. At the same time, the movable electrode is released, in that the insulating layer of the wafer includes an airgap at the area of the movable electrode. The movable electrode is thus made movable, but is nevertheless mechanically connected to other parts of the MEMS device. It is furthermore movable in specific directions. US Patent No. 5,408,112 shows another stress sensor.

The second semiconductor layer is herein used for handling purposes, and as part of the package for the sensor. The acceleration sensor is thus formed in a monocrystalline silicon layer forming part of a dedicated SOI substrate, in which the trenches are formed from the first side of the wafer. The resulting electrodes of the capacitors are facing each other in such a manner that the faces include a normal angle with the substrate plane.

It is a drawback of the known device that the device is not cost-effective in comparison to another known solution, in which the sensor and the semiconductor device are separately made and then assembled. This high cost results from the high number of additional masking steps (compared with the two-chip solution) and the limited yield. In a combined single-chip die, the area is normally bigger, hence the total yield is lower. The one-chip solution has however the disadvantage of a relatively small parasitic capacitance compared with the relatively large parasitic capacitance from the bonding pads and the chip-to-chip bond wires in the two-chip systems. The relatively small capacitance variations due to acceleration are difficult to detect in the presence of this large parasitic capacitance.

It is therefore a first object of the present invention to provide a method of the kind described in the opening paragraph, which is cost-effective and results in devices with a relatively small parasitic capacitance.

This object is achieved in that said MEMS device is formed in said second semiconductor layer in that the trenches are etched from the second side of the wafer down to the layer of insulating material.

Due to the provision of the MEMS device in the second semiconductor layer, the trenches can be manufactured from the second side of the wafer. As a consequence, the MEMS and the semiconductor circuit may be present at the same lateral portion of the wafer. This enables that the number of electronic devices per wafer can be maximized. As a result, the object of the invention is achieved.

It is observed that the most commonly used technique for forming known fully integrated accelerometers is surface micromachining, where the sensitive element is formed of polycrystalline silicon, for example, and suspended structures are formed by depositing and subsequently removing sacrificial layers. Using surface micromachining, the MEMS is etched in a relatively thick (2 -10 µm) polysilicon layer deposited on the chip. This requires special (i.e. expensive) cavity packages to assure that the mass can still move, or wafer level packaging where a second wafer is bonded on top of the first wafer. This second wafer has cavities where the MEMS structure is situated, and also needs etched-through holes to make contact to the bonding pads of the first wafer. It will be clear that this technique does not provide a cost-effective solution, and requires very many additional mask steps. Also a special and thus expensive package is required and the combination with advanced semiconductor processes for the manufacture of the semiconductor circuit causes problems.

It is an advantage that the first semiconductor layer can be designed to be relatively thin, at least much thinner than in the case that the MEMS device is defmed therein. This is particularly cost-effective in case that this first semiconductor layer is grown epitaxially. The provision of a package layer is not problematic in this case, because it can be provided on wafer level. The package layer can be attached to the wafer with glue. If however a fully hermetic package is desired, the use of solder appears preferable.

It is a second advantage that the dimensions of a structure can be made bigger by several microns as opposed to an increase in the sub-micron range, and that as a consequence the yield is increased as there are fewer killer defects.

It is another advantage that the electrodes of the MEMS device can have a much larger surface area. This has the advantage, in comparison with the provision of the MEMS device in the first semiconductor layer, that large variations in capacity can be achieved using only a single plate-like electrode. Another related advantage, particularly if the MEMS device is used as a sensor, is that the sensitivity of the sensor is increased due to the larger mass of the movable electrode. The thickness of the second semiconductor layer, and hence the surface area of the electrodes can be tuned by setting the thickness of this second semiconductor layer.

In a preferred embodiment the circuit comprises electrically conducting contacts that extend through the insulating layer, therewith enabling coupling of the reference electrode to the circuit, and the wafer is provided at its second side with a package layer, thereby encapsulating the MEMS device. With this embodiment, the MEMS device is allowed to be made in the second semiconductor layer effectively. It furthermore assures that the distance between the MEMS device and the semiconductor circuit is very short. The distance, and particularly the resistance of the path between electrode and circuit is important, in order to keep the signal-to-noise ratio as low as possible. Hence, by making the distance shorter, the effective sensitivity of the MEMS device is or can be increased.

In an advantageous embodiment, the method further comprises the step of etching a cavity at the second side of the wafer, which cavity is located at the area of the movable electrode. By selectively thinning the movable electrode, it is possible to use a planar package layer and to bond it directly at the second side of the wafer. Alternatively, the package layer can be provided with a cavity. This can be easily achieved, for instance if the package layer is a glass plate, by etching or by powder blasting cavities.

In another embodiment, the selective removal of the insulating layer includes the step of selective underetching, in which the insulating layer is exposed to an etchang that is provided from the second side of the wafer through the trenches. The use of underetching turns out to be a viable process for selective removal of the insulating layer. It has the advantage over the use of a wafer that includes an air-gap, that use can be made of standard SOI wafers.

It is preferred to use a dry etching process for the etching of the trenches and the underetching. The advantage thereof is that the etchants can be easily refreshed. Furthermore, the risk of sticking of the movable electrode to reference electrodes, as a consequence of capillary actions of liquid that has been left in the trenches, is prevented. In order to allow isotropic etching, use is advantagously made of a nitride for the insulating layer and that a fluorine chemistry is used for the dry etching process.

In a further embodiment, the semiconductor circuit including the contacts is provided by a sequence of steps prior to the provision of the trenches. Although it is possible that the manufacture of the semiconductor circuit is done by another company than the manufacture of the MEMS device, it appears suitable that both are manufactured in the same factory or by one company. This reduces the production chain and thus the manufacturing costs. In a modification hereof, selective removal of the insulating layer is part of the process at the first side of the wafer. Holes must be provided in the insulating layer anyway for the electrically conductive contacts. Additional holes provided in the same step enable the insulating layer to be etched away selectively. The holes can be made small, such as to maintain the stability of the first semiconductor layer. Furthermore, material can be provided at the first side of the wafer, so as to close these holes and make the package of the MEMS device hermetical.

If, however, the manufacturing of the MEMS device and the packaging is carried out by an assembly house or the like, it appears suitable that a mask for definition of the trenches is provided already in advance of the transfer of the wafer to such a house. Lithographic steps are usually undesirable in such assembly houses. Through the provision of the etch mask, the only steps are etching, packaging and separating.

In order to protect the first side of the wafer, a temporary handling wafer can be attached thereto. Such a wafer can be a glass wafer, which allows the use of an UV-releaseable adhesive. Alternatively, a wafer-scale coating can be applied at the first side, that may leave any bond pads at the first side exposed. Suitable layers for such protection layers include passivation layers, ceramic layers and organic layers. Particularly ceramic layers are preferred. These can be applied with sol-gel like processes and are very rigid so as to prevent damage. An example hereof is a system based on mono-aluminum phosphate (MAP).

The second semiconductor layer may be of any kind of semiconductor material, including monocrystalline and polycrystalline silicon. The quality of this material need not to be very high. If the conductivity is not sufficient, then the trenches can be coated with a layer of electrically conductive material.

In a further embodiment, a ring-shaped structure is etched from the second side in the same step as that where the etching of the trenches takes place. This structure is defined around said MEMS device, is connected to contacts through the insulating layer and is able to act as a shield. Such a shield may prevent that the MEMS device and/or the signals provided are disturbed electrically from outside. As particularly in sensors, the changes in capacity to be measured may be very small, any disturbance may give rise to undesired mistakes. The ring shape structure can for instance shield the MEMS device and/or the signals to the detection circuitry from driving signals for the sensor at relatively high voltages. The ring-shaped structure can be electrically connected in the circuit in and on top of the first semiconductor layer in a most effective and desired way.

It is a further object to provide an electronic device of the kind mentioned in the opening paragraph with a very small parasitic capacitance that can be cost-effectively manufactured.

This object is achieved in that the MEMS device is defined in the second semiconductor layer. The device has the advantages as explained above with reference to the method. In addition thereto, the density of the digital circuits can be increased. This is particularly advantageous in comparison with conventional combinations of detection circuits and sensors, in which the sensor is provided on the same side of the wafer as the detection circuit and in the same layer of polysilicon, because such a polysilicon layer must deposited at high temperature after the definition of the digital circuits. This limits the density (and the resolution) of the transistors used in the digital circuit. It thereby also reduces the speed of the digital circuit.

In a first embodiment, electrically conducting contacts are present which extend through the insulating layer so as to couple the MEMS device to the semiconductor circuit, and a package layer is present at the second side of the substrate, thereby encapsulating the MEMS device. This construction allows the use of a wafer-level package. This reduces the size of the electronic device, and it protects the MEMS device from an early stage in the manufacturing process. Furthermore, such a package solution is very cost effective.

In a preferred embodiment, there is a substantial overlap between the semiconductor circuit and the MEMS device, on perpendicular projection of the semiconductor circuit onto the second semiconductor layer. In this manner, a very cost-effective device is obtained, due to the adequate miniaturisation and the very low packaging costs.

In a further embodiment, the MEMS device is designed to act as a sensor and is able to provide an output electrical signal, said semiconductor circuit comprising circuit means for detection of said output signal. The device of the invention is particularly suitable for this embodiment.

MEMS devices are widely used in many applications. The advantages include low cost, a high degree of performance and reliability, better signal/noise ratio, integration with memory circuits for forming intelligent sensors and on-line self-test systems, and greater reproducibility and sensitivity. Important applications include accelerometers and pressure sensors for use in the automotive industry for airbags, ABS, active suspensions, engine control and ASR (Anti Slip Rotation). Most state of the art systems are based on a small mass that is suspended by springs. The mass and springs are etched in silicon or polysilicon. The moving part forms a capacitor with a static part. When the system experiences acceleration, small capacitance variations can be detected by a readout circuit. In one specific arrangement, acceleration induces displacement of a seismic mass forming the movable electrode of a single capacitor (absolute variation in capacitances). In an alternative arrangement, acceleration induces displacement of an electrode common to two electrically connected capacitors to vary the two capacitances in opposite directions (differential variation in capacitance).

In a suitable embodiment, the semiconductor circuit further comprises means for driving the sensor. This embodiment is advantageous in that the device comprises a complete subsystem without any substantial assembly.

The subsystem is, in a specific embodiment, an integrated accelerometer. It can be made by means of only one additional masking step (relative to existing two-chip solutions) and is characterized by a high sensitivity and low packaging cost. This is especially important for an airbag safety sensor bus. A sensor bus is being developed by Philips For Safe By Wire (SBW). This is a protocol for safety sensors and airbag firing squibs for use in cars. Currently, several impact sensors are used to send crash information to a central control unit. This central control unit uses the acceleration information to calculate what airbags should be deployed and at what time in order to maximise the protection for the passengers inside the car in the event of a crash. Slow sensors (occupant detection, child seat recognition, buckle switches) can also be multiplexed via SBW, as well as active reversible belt pre-tensioners.

It is a further advantage if the accelerometer can be integrated together with the signal processing circuits and the SBW protocol controller and transceiver. The currently available SBW sensor node is made in the ABCD3 process technology. This is a Silicon-On-Insulator (SOI) process that allows the integration of high voltage DMOS transistors with fairly dense CMOS digital circuits.

In a further embodiment, in order to protect the sensor and the detection circuit against high-frequency radiation from the bus, it is preferred to provide a ring-shaped protection zone around the sensor. This ring-shaped zone should be provided with contacts enabling a current or voltage to be provided thereon. Preferably the zone is slightly higher doped. It might even be that the sidewalls of this zone are covered with an electrically conductive layer, for instance polysilicon, or a metal. Solutions with metal particles (dispersed or as sol-gel system) are known per se.

These and other aspects of the present invention will be apparent from, and elucidated with reference to, the embodiment described hereinafter. An embodiment of the present invention will now be described by way of example only and with reference to the accompanying drawings, in which:
Figs. 1A - 1E are schematic cross-sectional views illustrating the process steps involved in a method according to an exemplary embodiment of the present invention;
Fig. 2 is a schematic plan view of an electronic device according to an exemplary embodiment of the present invention; and
Fig. 3 is block diagram illustrating the process flow of a method according to an exemplary embodiment of the present invention.

As explained above, acceleration sensors are widely used in the automotive industry and, in recent times, electromechanical silicon microstructures fabricated using microelectronics technology have been proposed for use as acceleration sensors, in view of the numerous advantages afforded thereby as compared with traditional microscopic inertial mechanical switches.

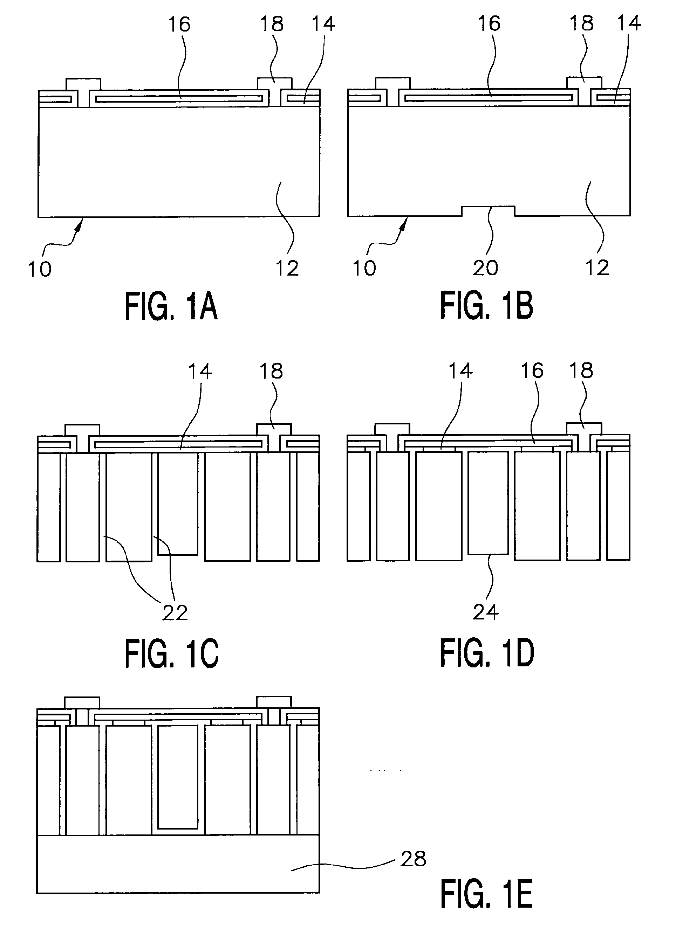

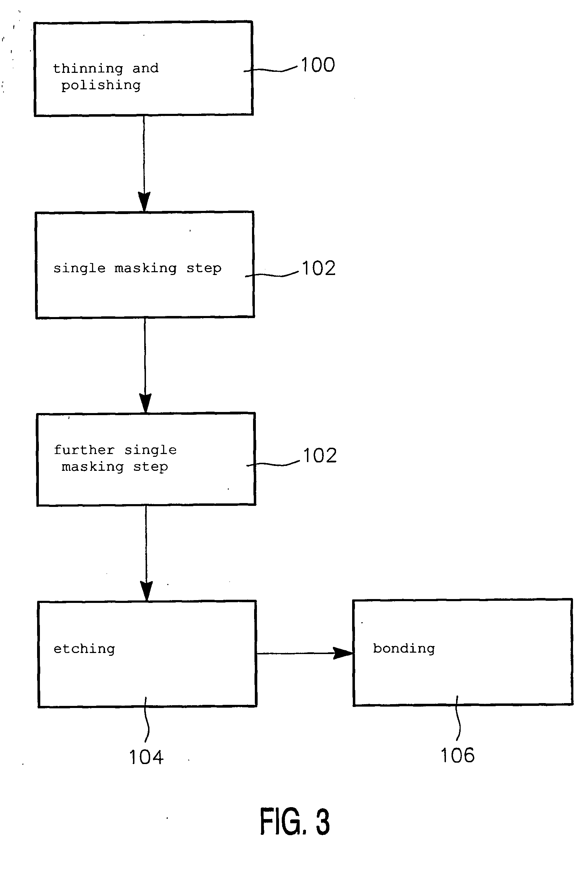

Referring to Figs. 1 and 3 of the drawings, in accordance with an exemplary embodiment of the present invention, a bonded SOI wafer 10 is provided by means of a process known to a person skilled in the art, the wafer 10 having a second semiconductor layer 12, in this case of base silicon. This layer will also be referred to as the handling wafer. The SOI wafer further comprises an intermediate, buried oxide layer 14, and a first semiconductor layer 16 on its first side (Fig. 1A). Handle wafer contacts 18 are also provided for the provision of a well-defined potential at the handling wafer 12. The wafer 10 is first thinned and polished (step 100) from the second side. If necessary, additional support can be provided by a transparent support wafer removably attached to the first side of the wafer 10 by means of, for example a UV-glue.

A single masking step 102 is employed to etch a small cavity 20 on the second side of the wafer 10 (in the second semiconductor layer 12), the cavity 20 being where the proof mass will be (Fig. 1B).

A further single masking step 102 is carried out to etch deep trenches 22 from the second side of the wafer down to the buried oxide layer 14. Processes for the etching of vertical trenches are known to persons skilled in the art, such as that described in F. Roozeboom, R.J.G. Elfrink, Th.G.S.M. Rijks, J.F.C.M. Verhoeven, A. Kemmeren and J.E.A.M. van den Meerakker, "High-Density, Low Loss Capacitors for Integrated RF Decoupling", Int. J. Microcircuits and Electronic Packaging, 24(3)(2001) pp. 182-196. In this document two different types of etching techniques are described: wet etching and dry etching. Wet etching is an anisotropic etching technique based on the preferential anodic dissolution of n-type Si in aqueous HF in the etch pit regions where the holes are collected more efficiently due to the enhanced electrical field in the space charge layer. When the rate-determining step for dissolution is controlled by the number of holes, generated by white light illumination of the wafer backside, the pore walls become depleted of the minority carriers (holes) that drive the dissolution and thus passivated.

An alternative, dry etching, process is Reactive Ion Etching (RIE) where, in a time-multiplexed way, the pores are etched anisotropically by alternatively introducing SF₆/O₂ and C₄F₈ gas into a plasma. The former gas etches the pore and the latter forms a passivation layer on the pore walls.

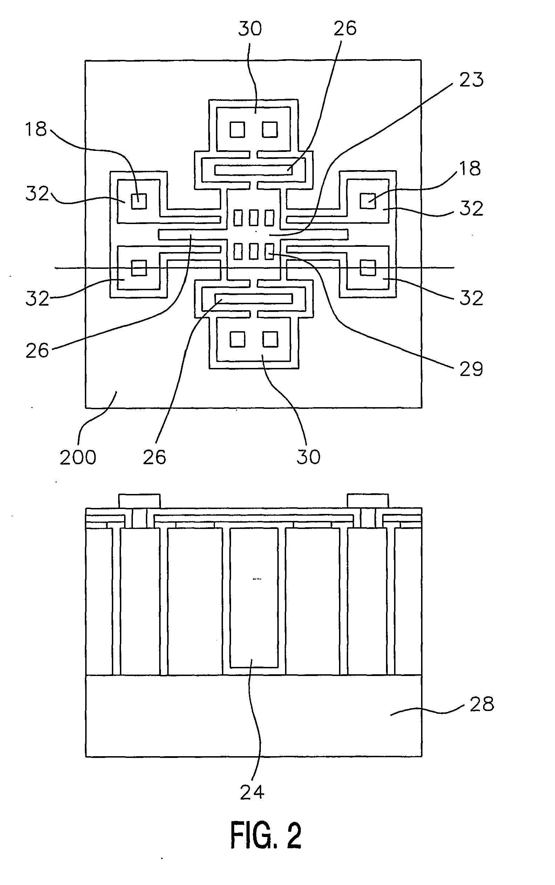

As illustrated in Fig. 1D, the etching step 104 involves selective etching of the oxide layer 14. This releases the proof mass 23, the moving capacitor plates 24 and the springs 26 (see Fig. 2).

Finally, a package layer 28 is bonded on the second side of the wafer (step 106), providing greater stability and hermetic sealing of the MEMS device.

Accordingly, referring to Fig. 2 of the drawings, an electronic device according to an exemplary embodiment of the present invention is manufactured, comprising a silicon chip 200 in which the trench is etched, a proof mass 23 (in which holes 29 are provided to allow etching of the buried oxide), springs 26 and moving capacitor plates 24 (having anchor points 30) the springs 26 being connected to the anchor points 30 on one side and the proof mass 23 on the other side, and the moving capacitor plates 24 being attached to the proof mass 23, and fixed or reference capacitor plates (having anchor and electrical contact points 32).

The principle of sensing in the embodiment described above is capacitive: the movable part is provided with one or more electrodes. Movement of the part in a certain direction results in a displacement of the electrodes. The displacement brings the electrodes nearer to one of the sensing electrodes and further away from the other sensing electrodes. The resulting differences in capacity and/or their changes in time are measured.

The circuitry at the front side comprises particularly the detection circuitry for the sensor. In addition thereto, other functions can be present. Particularly, it relates to a system which is characterized by a two-wire bus. The voltage supply is taken from this bus, and then transformed and used so as to drive the sensor and the detection circuit. In order to realize this, in accordance with this exemplary embodiment, both high-voltage DMOS and low-voltage digital CMOS transistors are present at the front side.

It will be appreciated in respect of the exemplary embodiment described above, that the provision of the sensor at the second semiconductor layer is, in fact, realized in that contacts are present to contact the structure in the second semiconductor layer from the first side of the wafer. These contacts are known per se, and also implemented in the known process for the provision of a well-defined potential at the handling wafer. As will be appreciated by a person skilled in the art, the handle wafer is contacted by manufacturing a defined hole in the buried oxide layer through which an ohmic contact is established.

First, a hole is etched in the top silicon layer, removing most of the silicon. This can be done either by wet etching or dry etching. In both cases the remaining silicon is oxidized until the buried oxide layer is reached. Thereafter, the thermally grown silicon oxide and the buried oxide layer may be etched consecutively in a single wet etch operation.

The structure illustrated in Fig 2 shows seven columns. The columns to which the contacts are provided, are the sensor electrodes. As can be seen in Fig 2, these columns are more or less L-shaped. The column in the middle is the movable part of the sensor. Its shape is more apparent from Fig 2. The parts 30 therein are the supports, the parts 26 are spring-like structures. The other 4 columns are part of the handling wafer surrounding the sensor.

It will be appreciated by a person skilled in the art, that the movable electrode can be embodied as a single plate, due to the larger thickness of the handling wafer, whereas in the prior art, this is generally a comb structure. However, the present invention is not intended to be limited in this regard.

The package layer used for capping may comprise any body that can be applied at the second side of the wafer. Examples include glass plates, polymer plates and semiconductor wafers. In the case of semiconductor wafers, an oxide layer may be needed, so as to provide electrical insulation between the individual contact areas. The third wafer may be attached to the handling wafer by means of a suitable glue.

In order to improve the conductivity of the capacitive plates, these can be coated with an electrically conductive material.

In order to protect the sensor and the detection circuit against high-frequency radiation from the bus, it is preferred to provide a ring-shaped protection zone around the sensor. This ring-shaped zone should be provided with contacts, so that a current or voltage can be provided thereon. Preferably, the zone is slightly more doped. It might even be that the side walls of this zone are covered with an electrically conductive layer, for instance polysilicon, or a metal. Solutions with metal particles (dispersed or as sol-gel system) will be apparent to a person skilled in the art.

Although it is preferred to provide the MEMS-structures after the completion of the integrated circuit, the reverse order (i.e. first making the MEMS, then the integrated circuit) is also envisaged.

It will also be appreciated that the substrate is generally not heavily doped, but the sensor part of it may of course be doped more heavily so as to improve the conductivity of the material.

The main field of application of the present invention is integrated crash sensors for Safe By Wire (airbag sensor bus system). Of course, however, the described technique can be applied to other integrated MEMS devices as well, for example, pressure sensors.

Two significant advantages of the arrangement described above are the relatively low mask count and simplified wafer scale packaging. Both result in a significantly lower cost than existing solutions. This is realised by making the accelerometer sensor in the handle wafer (comparable to bulk MEMS). This is done by etching very deep trenches from the back of the wafer, until the buried oxide is reached. The buried oxide is etched to release the proof mass. It is the existing buried oxide that is used as the sacrificial layer. The existing handle wafer contacts provide the electrical connection.

As the wafer is relatively thick (100 -200 µm), large capacitance variations can be achieved with only a single plate (as compared to the much thinner polysilicon layer used in surface MEMS). Also, the proof mass is larger, which increases sensitivity.

The moving part is not exposed from the top side. Most metal and dielectric layers of the back-end process can be applied on top of the MEMS structure to improve stiffness. In order to seal the bottom of the structure, either a wafer with predefined cavities can be bonded, or the cavities can be etched prior to trench etching. In the latter case, a flat wafer can be used for sealing. The advantage of this solution is that nothing special needs to be done to provide electrical contact for bonding wires.

It should be noted that the above-mentioned embodiment illustrates rather than limits the invention, and that those skilled in the art will be capable of designing many alternative embodiments without departing from the scope of the invention as defined by the appended claims. In the claims, any reference signs placed in parentheses shall not be construed as limiting the claims. The word "comprising" and "comprises", and the like, does not exclude the presence of elements or steps other than those listed in any claim or the specification as a whole. The singular reference of an element does not exclude the plural reference of such elements and vice-versa. The invention may be implemented by means of hardware comprising several distinct elements, and by means of a suitably programmed computer. In a device claim enumerating several means, a number of these means may be embodied by one and the same item of hardware. The mere fact that certain measures are recited in mutually different dependent claims does not indicate that a combination of these measures cannot be used to advantage.

## Claims

1. A method of manufacturing an electronic device, comprising:
- providing a wafer (10) with a first and an opposed second side, having first and second semiconductor layers (12,16) with at least a layer of insulating material (14) therebetween, at which first side a semiconductor circuit is provided comprising semiconductor elements that are defined in the first semiconductor layer;
- forming a micro-electromechanical systems (MEMS) device comprising a movable electrode and a reference electrode in said wafer by etching trenches according to a desired pattern extending substantially perpendicularly to a plane in a wafer, and releasing the movable electrode in that the trenches extend to the layer of insulating material that is selectively removed,
**characterized in that** said MEMS device is formed in said second semiconductor layer (12) **in that** the trenches are etched from the second side of the wafer down to the layer of insulating material, and that the circuit comprises electrically conducting contacts that extend through the insulating layer (14), therewith enabling coupling of the reference electrode to the circuit.

2. A method as claimed in claim 1, wherein the wafer is provided at its second side with a package layer, thereby encapsulating the MEMS device.

3. A method as claimed in claim 1, further comprising the step of etching a cavity in the second semiconductor layer, which cavity is located at the area of the movable electrode.

4. A method according to claim 1, wherein the selective removal includes the step (104) of selective underetching, in which the layer is exposed to an etchant, that is provided from the second side of the wafer through the trenches.

5. A method as claimed in claim 1, wherein the semiconductor circuit including the contacts is provided by a sequence of steps prior to the provision of the trenches.

6. A method as claimed in claim 1, wherein the electrodes are covered by an electrically conductive material.

7. A method as claimed in claim 1, wherein furthermore a ring-shaped structure is etched during the etching of the trenches, said structure being defined around said MEMS device, being connected to contacts through the insulating layer and being able to act as a shield.

8. A method as claimed in claim 1, wherein the wafer is subdivided into a plurality of individual devices after the provision of the package layer.

9. An electronic device, comprising a substrate (10) with a first and an opposed second side, having first and second semiconductor layers (12,16) with at least a layer of insulating material (14) therebetween, at which first side a semiconductor circuit is present comprising semiconductor elements that are defined in the first semiconductor layer, and further comprising a micro-electromechanical systems (MEMS) device, said MEMS device having a reference electrode and a movable electrode, said MEMS device being electrically coupled to said semiconductor circuit, said insulating layer being removed locally so as to allow the movable electrode to be movable,
**characterized in that** the MEMS device is defined in the second semiconductor layer, and electrically conducting contacts are present which extend through the insulating layer so as to couple the MEMS device to the semiconductor circuit.

10. An electronic device as claimed in claim 9, wherein a package layer is present at the second side of the substrate, thereby encapsulating the MEMS device.

11. A device as claimed in claim 9, **characterized in that**, on perpendicular projection of the semiconductor circuit onto the second semiconductor layer, there is a substantial overlap with the MEMS device.

12. A device as claimed in claim 9, wherein the movable electrode has a length in a direction perpendicular to the substrate plane that is shorter than the thickness of the second semiconductor layer.

13. A device as claimed in claim 9, **characterized in that** said MEMS device is designed to act as a sensor and is able to provide an output electrical signal, said semiconductor circuit comprising circuit means for detection of said output electrical signal.

14. A device as claimed in claim 9 or 13, **characterized in that** the semiconductor circuit further comprises means for driving the MEMS device.

15. A device as claimed in claim 14, **characterized in that** the means for driving comprise DMOS transistors and the means for detection comprise CMOS transistors.

16. A device as claimed in any one of the claims 9 to 14, which is further provided with a ring-shaped structure that is present around said MEMS device, said structure being connected to contacts through the insulating layer and being able to act as a shield.

## Patentansprüche

1. Verfahren zur Herstellung einer elektronischen Einrichtung, das Folgendes umfasst:
- Versehen einer Scheibe (10) mit einer ersten und einer gegenüberliegenden zweiten Seite mit ersten und zweiten Halbleiterschichten (12, 16) mit mindestens einer Schicht isolierenden Materials (14) dazwischen, wobei auf dieser ersten Seite eine Halbleiterschaltung mit Halbleiterelementen, die in der ersten Halbleiterschicht definiert sind, geschaffen wird;
- Bilden einer "mikroelektromechanisches System"-Einrichtung (MEMS-Einrichtung) mit einer beweglichen Elektrode und einer Referenzelektrode in der genannten Scheibe durch Ätzen von Gräben gemäß einem gewünschten Muster, die sich im Wesentlichen senkrecht zu einer Ebene in einer Scheibe erstrecken, und Lösen der beweglichen Elektrode **dadurch**, dass die Gräben sich bis zu der Schicht isolierenden Materials erstrecken, das selektiv entfernt wird,
**dadurch gekennzeichnet, dass** die genannte MEMS-Einrichtung in der genannten zweiten Halbleiterschicht (12) **dadurch** gebildet wird, dass die Gräben von der zweiten Seite der Scheibe nach unten bis zu der Schicht isolierenden Materials geätzt werden, und dass die Schaltung elektrisch leitende Kontakte umfasst, die sich durch die isolierende Schicht (14) erstrecken, wobei sie Kopplung der Referenzelektrode zu der Schaltung ermöglichen.

2. Verfahren nach Anspruch 1, in dem die Scheibe an ihrer zweiten Seite mit einer Gehäuseschicht versehen wird, wobei dabei die MEMS-Einrichtung verkapselt wird.

3. Verfahren nach Anspruch 1, das weiter den Schritt des Ätzens eines Hohlraums in die zweite Halbleiterschicht umfasst, wobei der Hohlraum am Ort der Fläche der beweglichen Elektrode liegt.

4. Verfahren nach Anspruch 1, in dem das selektive Entfernen den Schritt (104) des selektiven Unterätzens umfasst, in dem die Schicht einem Ätzmittel ausgesetzt wird, das von der zweiten Seite der Scheibe durch die Gräben bereitgestellt wird.

5. Verfahren nach Anspruch 1, in dem die Halbleiterschaltung inklusive der Kontakte durch eine Folge von Schritten vor der Schaffung der Gräben geschaffen wird.

6. Verfahren nach Anspruch 1, in dem die Elektroden mit einem elektrisch leitendem Material bedeckt werden.

7. Verfahren nach Anspruch 1, in dem außerdem während des Ätzens der Gräben eine ringförmige Struktur geätzt wird, wobei die genannte Struktur um die genannte MEMS-Einrichtung herum definiert ist, an Kontakte durch die isolierende Schicht angeschlossen ist und in der Lage ist, als eine Abschirmung zu fungieren.

8. Verfahren nach Anspruch 1, in dem die Scheibe nach dem Aufbringen der Gehäuseschicht in eine Vielzahl individueller Einrichtungen unterteilt wird.

9. Elektronische Einrichtung, die Folgendes umfasst: ein Substrat (10) mit einer ersten und einer gegenüberliegenden zweiten Seite mit ersten und zweiten Halbleiterschichten (12, 16) mit mindestens einer Schicht isolierenden Materials (14) dazwischen, wobei auf dieser ersten Seite eine Halbleiterschaltung mit Halbleiterelementen, die in der ersten Halbleiterschicht definiert sind, vorhanden ist, und die weiter eine "mikroelektromechanisches System"-Einrichtung (MEMS-Einrichtung) umfasst, wobei die genannte MEMS-Einrichtung eine Referenzelektrode und eine bewegliche Elektrode hat, die genannte MEMS-Einrichtung elektrisch an die genannte Halbleiterschaltung gekoppelt ist, die genannte isolierende Schicht lokal entfernt worden ist, um der beweglichen Elektrode zu erlauben, beweglich zu sein,
**dadurch gekennzeichnet, dass** die genannte MEMS-Einrichtung in der genannten zweiten Halbleiterschicht definiert ist, und elektrisch leitende Kontakte vorhanden sind, die sich durch die isolierende Schicht erstrecken, um die MEMS-Einrichtung an die Halbleiterschaltung zu koppeln.

10. Elektronische Einrichtung nach Anspruch 9, in der an der zweiten Seite des Substrats eine Gehäuseschicht vorhanden ist, wobei dabei die MEMS-Einrichtung verkapselt wird.

11. Einrichtung nach Anspruch 9, **dadurch gekennzeichnet, dass**, in senkrechter Projektion der Halbleiterschaltung auf die zweite Halbleiterschicht, es eine beträchtliche Überlappung mit der MEMS-Einrichtung gibt.

12. Einrichtung nach Anspruch 9, in der die bewegliche Elektrode in einer Richtung senkrecht zu der Substratebene eine Länge hat, die kürzer als die Dicke der zweiten Halbleiterschicht ist.

13. Einrichtung nach Anspruch 9, **dadurch gekennzeichnet, dass** die genannte MEMS-Einrichtung designt ist, als Sensor zu fungieren und in der Lage ist, ein elektrisches Ausgangssignal zu liefern, wobei die genannte Halbleiterschaltung Schaltungsmittel zum Detektieren des genannten elektrischen Ausgangssignals umfasst.

14. Einrichtung nach Anspruch 9 oder 13, **dadurch gekennzeichnet, dass** die Halbleiterschaltung weiter Mittel zum Treiben der MEMS-Einrichtung umfasst.

15. Einrichtung nach Anspruch 14, **dadurch gekennzeichnet, dass** die Mittel zum Treiben DMOS-Transistoren umfassen und die Mittel zum Detektieren CMOS-Transistoren umfassen.

16. Einrichtung nach einem der Ansprüche 9 bis 14, die weiter mit einer ringförmigen Struktur versehen ist, die um die genannte MEMS-Einrichtung herum vorhanden ist, wobei die genannte Struktur an Kontakte durch die isolierende Schicht angeschlossen ist und in der Lage ist, als Abschirmung zu fungieren.

## Revendications

1. Procédé de fabrication d'un dispositif électronique, comprenant les étapes suivantes:
- la formation d'une plaquette (10) comportant un premier côté et un deuxième côté opposé, comportant des première et deuxième couches semi-conductrices (12, 16) comportant au moins une couche de matériau isolant (14) entre elles, premier côté au niveau duquel est formé un circuit à semi-conducteur comprenant des éléments à semi-conducteur qui sont définis dans la première couche semi-conductrice;
- la formation d'un dispositif MEMS (Micro-ElectroMechanical System/microsystème électromécanique) comprenant une électrode mobile et une électrode de référence dans ladite plaquette en gravant des tranchées selon un motif souhaité s'étendant sensiblement perpendiculairement à un plan dans une plaquette, et la libération de l'électrode mobile en ce que les tranchées s'étendent jusqu'à la couche de matériau isolant qui est éliminée de manière sélective;
**caractérisé en ce que** ledit dispositif MEMS est formé dans ladite deuxième couche semi-conductrice (12) **en ce que** les tranchées sont gravées à partir du deuxième côté de la plaquette en descendant jusqu'à la couche de matériau isolant, et **en ce que** le circuit comprend des contacts conducteurs de l'électricité qui s'étendent à travers la couche isolante (14), permettant de ce fait la connexion de l'électrode de référence au circuit.

2. Procédé suivant la revendication 1, dans lequel la plaquette est pourvue en son deuxième côté d'une couche d'encapsulation, encapsulant de ce fait le dispositif MEMS.

3. Procédé suivant la revendication 1, comprenant en outre l'étape de gravure d'une cavité dans la deuxième couche semi-conductrice, laquelle cavité se trouve dans la région de l'électrode mobile.

4. Procédé suivant la revendication 1, dans lequel l'élimination sélective inclut l'étape (104) de sous-gravure sélective, dans laquelle la couche est exposée à un agent de gravure, qui est déposé à partir du deuxième côté de la plaquette à travers les tranchées.

5. Procédé suivant la revendication 1, dans lequel le circuit à semi-conducteur comprenant les contacts est formé par une succession d'étapes avant la formation des tranchées.

6. Procédé suivant la revendication 1, dans lequel les électrodes sont recouvertes d'un matériau conducteur de l'électricité.

7. Procédé suivant la revendication 1, dans lequel une structure annulaire est en outre gravée pendant la gravure des tranchées, ladite structure étant définie autour dudit dispositif MEMS, étant connectée à des contacts à travers la couche isolante et pouvant servir d'écran.

8. Procédé suivant la revendication 1, dans lequel la plaquette est subdivisée en une pluralité de dispositifs individuels après le dépôt de la couche d'encapsulation.

9. Dispositif électronique, comprenant un substrat (10) muni d'un premier côté et d'un deuxième côté opposé, comportant des première et deuxième couches semi-conductrices (12, 16) comportant au moins une couche de matériau isolant (14) entre elles, premier côté au niveau duquel est présent un circuit à semi-conducteur comprenant des éléments à semi-conducteur qui sont définis dans la première couche semi-conductrice, et comprenant en outre un dispositif MEMS, ledit dispositif MEMS comportant une électrode de référence et une électrode mobile, ledit dispositif MEMS étant électriquement connecté audit circuit à semi-conducteur, ladite couche isolante étant éliminée localement de manière à permettre à l'électrode mobile de se déplacer;
**caractérisé en ce que** le dispositif MEMS est défini dans la deuxième couche semi-conductrice, et **en ce que** sont présents des contacts conducteurs de l'électricité qui s'étendent à travers la couche isolante de manière à connecter le dispositif MEMS au circuit à semi-conducteur.

10. Dispositif électronique suivant la revendication 9, dans lequel une couche d'encapsulation est présente au niveau du deuxième côté du substrat, encapsulant de ce fait le dispositif MEMS.

11. Dispositif suivant la revendication 9, **caractérisé en ce que**, sur une saillie perpendiculaire du circuit à semi-conducteur sur la deuxième couche semi-conductrice, il existe un chevauchement important avec le dispositif MEMS.

12. Dispositif suivant la revendication 9, dans lequel l'électrode mobile présente une longueur dans une direction perpendiculaire au plan du substrat qui est inférieure à l'épaisseur de la deuxième couche semi-conductrice.

13. Dispositif suivant la revendication 9, **caractérisé en ce que** ledit dispositif MEMS est conçu pour servir de capteur et peut fournir un signal électrique de sortie, ledit circuit à semi-conducteur comprenant des circuits pour la détection dudit signal électrique de sortie.

14. Dispositif suivant la revendication 9 ou 13, **caractérisé en ce que** le circuit à semi-conducteur comprend en outre des moyens pour attaquer le dispositif MEMS.

15. Dispositif suivant la revendication 14, **caractérisé en ce que** les moyens d'attaque comprennent des transistors MOS à double diffusion et les moyens de détection comprennent des transistors MOS complémentaires.

16. Dispositif suivant l'une quelconque des revendications 9 à 14, qui est en outre pourvu d'une structure annulaire qui est présente autour dudit dispositif MEMS, ladite structure étant connectée à des contacts à travers la couche isolante et pouvant servir d'écran.
